# DEMANDE DE BREVET EUROPEEN

(11) **EP 0 701 319 A1**
(43) Date de publication de la demande: **13.03.1996**
(21) Numéro de dépôt: 95402001.2
(22) Date de dépôt: 04.09.1995
(51) Int. Cl.: H02N 13/00, H01L 21/00

(54) **Porte-substrat électrostatique**

(30) Priorité: 06.09.1994 FR 9410647
(71) Demandeur: COMMISSARIAT A L'ENERGIE ATOMIQUE, F-75015 Paris (FR)
(72) Inventeur: Peccoud, Louise, F-38640 Claix (FR); Pellegrin, Philippe, F-34000 Montpellier (FR)
(74) Mandataire: Dubois-Chabert, Guy

(57) **Abrégé**

L'invention concerne un porte-substrat électrostatique à double face comportant une semelle de maintien (2) assurant le maintien dans une position fixe du substrat (1) par collage électrostatique, cette semelle de maintien (2) étant elle-même rendue solidaire du support (3) par un collage électrostatique.

Application dans l'industrie électronique.

## Description

### Domaine technique

L'invention a pour objet un porte-substrat électrostatique à double face. Elle trouve une application dans le domaine industriel de l'électronique, notamment pour la mise en oeuvre de procédés de traitements des substrats.

### Etat de la technique

Dans l'industrie électronique, les substrats en forme de disques ou de plaquettes sont très souvent soumis à des traitements (tels que, par exemple, des gravures ou des dépôts ou des implantations ioniques) pour lesquels ils doivent être maintenus en position fixe et à une température contrôlée. A cette fin, on utilise généralement des porte-substrats dont on connaît de nombreux types différents.

A ce jour, les porte-substrats les plus intéressants sont les porte-substrats électrostatiques.

Par exemple, le document GB-1 443 215 décrit un porte-substrat électrostatique comportant une couche de matériau diélectrique recouvrant un support électriquement conducteur. La plaquette semiconductrice à traiter (nommée aussi substrat) est alors positionnée sur le porte-substrat et maintenue en contact avec la couche diélectrique par collage grâce à une force électrostatique. Cependant, un tel porte-substrat nécessite de maintenir d'une part le support conducteur et d'autre part la plaquette à des potentiels électriques différents, ce qui, dans la plupart des applications, est très difficile à mettre en oeuvre.

Le document US-A-5 055 964 décrit un autre type de porte-substrat électrostatique. Ce porte-substrat comporte un support sur lequel sont disposées sur la même face deux électrodes distinctes portées chacune à des potentiels différents. Ces deux électrodes sont recouvertes d'une couche de matériau diélectrique et maintenues ensemble sur le support au moyen d'une colle époxy. Ce porte-substrat est donc réalisé d'un seul tenant. En outre, la couche de matériau diélectrique est très fine, ce qui la rend bien entendu fort fragile. Les conséquences de ces caractéristiques sont que, lorsque la couche diélectrique est détériorée, tout l'ensemble du porte-substrat doit être remplacé, ce qui entraîne une maintenance lourde, en temps et en coût.

Le document FR-A-2 661 039 déposé au nom du demandeur décrit encore un autre type de porte-substrat électrostatique. Ce porte-substrat comporte un support sur lequel sont fixées une électrode filifome s'étendant sous la périphérie du substrat, et une électrode continue, pleine et entourée par la précédente. Cette électrode pleine forme, avec le substrat, un condensateur plan lors des traitements sous plasma conducteur.

Ce porte-substrat est également réalisé d'un seul tenant. Il présente donc des inconvénients similaires à ceux du porte-substrat décrit dans le document US-A-5 055 964. Il en est d'ailleurs de même pour tous les porte-substrats électrostatiques dont la semelle de maintien du substrat (c'est-à-dire la partie réalisant le collage électrostatique du substrat) est fixée sur le support de manière irréversible, c'est-à-dire par collage, soudure, brasage, etc...

### Exposé de l'invention

La présente invention a justement pour but de remédier aux inconvénients des porte-substrats décrits précédemment. A cette fin, elle propose un porte-substrat électrostatique à double face comportant une semelle assurant le maintien du substrat par collage électrostatique, cette semelle étant elle-même fixée sur le support par collage électrostatique.

De façon plus précise, l'invention concerne un porte-substrat électrostatique comprenant :
- une semelle de maintien ayant une surface de contact supérieure apte à supporter un substrat et à le maintenir dans une position choisie par collage électrostatique, et
- un support solidaire de ladite semelle de maintient.

Ce porte-substrat se caractérise par le fait que la semelle de maintien comporte en outre une surface de contact inférieure adhérant au support par collage électrostatique.

Avantageusement, la semelle de maintien comporte une pièce plate électriquement isolante et thermiquement conductrice, ayant une face supérieure recouverte par au moins deux électrodes concentriques portées à des potentiels différents et une face inférieure recouverte d'au moins une électrode, chacune de ces électrodes étant elle-même recouverte d'une couche de matériau diélectrique.

Selon un mode de réalisation de la semelle de maintien, la pièce plate est réalisée en un matériau thermiquement conducteur recouvert d'au moins une couche de matériau électriquement isolant.

Selon l'invention, chaque électrode de la pièce plate est portée à une tension choisie, amenée au moyen d'un connecteur de tension.

La pièce plate peut comporter, pour chaque électrode recouvrant la face supérieure de ladite pièce plate, au moins un orifice transversal débouchant en regard de l'électrode et assurant le passage d'un connecteur de tension.

Selon un mode de réalisation de l'invention, la semelle de maintien comporte un circuit d'écoulement d'un gaz caloporteur réalisé en surface de la couche de matériau diélectrique.

### Brève description des dessins

- la figure 1 représente schématiquement une vue de face du porte-substrat conforme à l'invention ;
- la figure 2 représente schématiquement une vue de face de la semelle de maintien du porte-substrat conforme à l'invention ; et
- la figure 3 représente une portion du porte-substrat traversé par un connecteur de tension.

### Description de modes de réalisation de l'invention

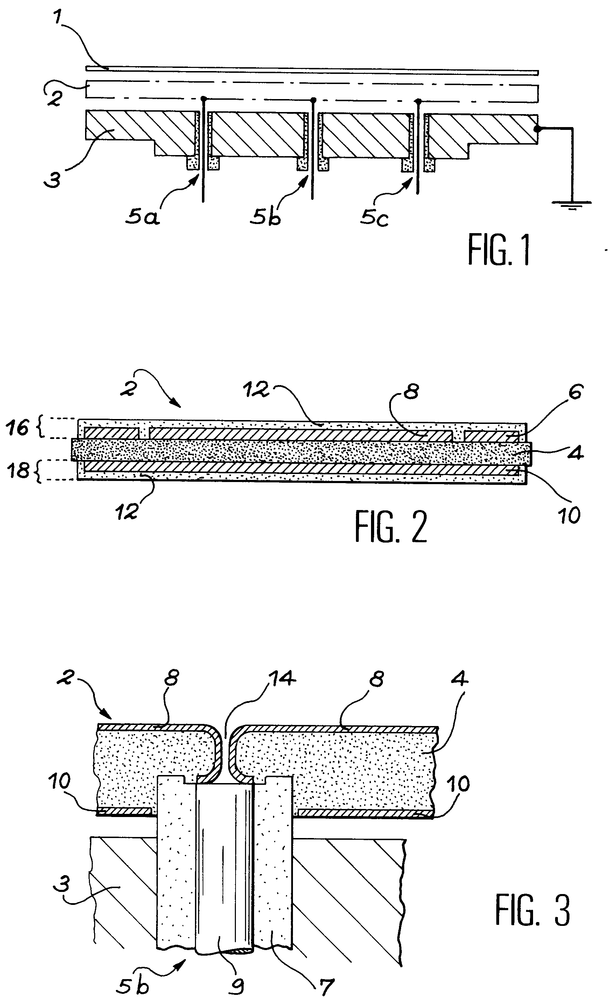

Sur la figure 1, on a représenté de façon schématique le porte-substrat électrostatique à double face conforme à l'invention. Sur cette figure 1, le substrat porte la référence 1, la semelle de maintien du substrat porte la référence 2 et le support de ce porte-substrat porte la référence 3.

Dans toute la description, on parlera indifféremment de substrat ou de plaquette. Classiquement, il peut s'agir d'une plaquette en semiconducteur (Si, AsGa, ...) ou bien d'une plaquette en matériau isolant (par exemple du verre) revêtue d'un film conducteur sur sa face en contact avec le porte-substrat ou encore, tout simplement, d'une plaquette en métal.

Cette figure 1 montre donc que, contrairement au porte-substrat de l'art antérieur, le porte-substrat de l'invention comporte une semelle de maintien 2 qui ne fait pas partie intégrante du support 3.

D'une part, une telle semelle de maintien 2 permet de supporter le substrat 1 et de le maintenir dans la position fixe désirée ; d'autre part, elle est apte à se fixer sur le support 3 de façon à être solidaire de ce support. Le maintien du substrat 1 sur la semelle de maintien 2 ainsi que l'adhésion de cette semelle de maintien 2 sur le support 3 sont réalisés par un procédé identique de collage électrostatique.

Afin de créer des forces électrostatiques nécessaires au collage, d'une part, du substrat 1 sur la semelle de maintien 2 e,t d'autre part, de la semelle de maintien 2 sur le support 3, des connecteurs référencés 5a, 5b et 5c assurent une amenée de tension sur les différentes électrodes incluses dans la semelle de maintien 2. Ces connecteurs de tension seront décrits plus en détails ultérieurement. Le support 3 comporte donc des orifices traversant ledit support de part en part et débouchant au droit de la semelle de maintien 2. Ces orifices, non représentés sur la figure 1 par mesure de simplification, permettent aux connecteurs 5a, 5b et 5c de traverser le support 3 pour venir établir un contact avec les différentes électrodes de la semelle de maintien 2.

Selon l'invention, on utilise autant de connecteurs qu'il y a d'électrodes dans la semelle de maintien 2. Aussi, pour le mode de réalisation représenté sur la figure 1 dans lequel la semelle de maintien 2 comporte trois électrodes, trois connecteurs sont nécessaires. Ces trois connecteurs 5a, 5b et 5c amènent sur les électrodes de la semelle de maintien 2 des tensions, qui peuvent être de valeurs différentes.

En outre, comme montré sur cette figure 1, le support 3 est connecté à la masse.

Sur la figure 2, on a représenté schématiquement une vue de face en coupe de la semelle de maintien 2. Cette semelle 2 de maintien du substrat comporte une pièce plate, référencée 4, qui a la propriété d'être électriquement isolante mais thermiquement conductrice.

Selon un mode de réalisation de l'invention, cette pièce plate 4 peut être réalisée dans une céramique en Al₂O₃ d'une épaisseur suffisante pour lui permettre d'avoir une bonne tenue mécanique et d'être suffisamment facile à usiner ; elle peut, à titre d'exemple, avoir une épaisseur variant de 1 à 10 mm.

Selon un autre mode de réalisation de l'invention, cette pièce plate 4 peut consister en un support plan réalisé dans un matériau très bon conducteur thermique (tel que, par exemple, le graphite ou le cuivre ou l'aluminium) et entouré d'une couche de matériau isolant (tel que, par exemple, l'aluminium anodisé).

Selon l'invention, la semelle de maintien 2 comporte trois électrodes référencées respectivement 6, 8 et 10. Les électrodes 6 et 8 sont déposées sur la face supérieure de la pièce plate 4. Comme on le voit sur cette figure 2, l'électrode 6 est une électrode filiforme qui s'étend sensiblement sous le périmètre du substrat. L'électrode 8 est une électrode pleine entourée par l'électrode 6 et dont la surface correspond sensiblement à la surface du substrat 1. Ces électrodes 6 et 8, concentriques, sont portées à des potentiels différents.

Pour de plus amples détails sur la réalisation de ces électrodes 6 et 8, on pourra se reporter au document FR-A-2 661 039 briévement décrit. La semelle de maintien 2 comporte en outre une troisième électrode, référencée 10. Cette dernière est déposée sur la face inférieure de la pièce plate 4. Elle a une périphérie sensiblement équivalente à celle de l'électrode 6, mais, contrairement à cette électrode 6, elle recouvre quasi-entièrement la face inférieure de la pièce plate 4.

Ces électrodes 6, 8 et 10 peuvent être réalisées, classiquement, par dépôt sous vide ou par tout autre moyen permettant d'obtenir une couche mince de matériau conducteur. L'épaisseur de ces électrodes est de préférence comprise entre environ de 500 Å et 20 µm.

L'ensemble constitué de la pièce plate 4 et des électrodes 6, 8 et 10 est entièrement recouvert d'une couche de contact 12 de quelques dixièmes de millimètres réalisée dans un matériau diélectrique.

Pour la suite de la description, on appellera, par exemple, surface de contact supérieure la partie de la semelle de maintien 2 située sur la face supérieure de la pièce plate 4 et comportant, notamment, les électrodes 6 et 8 et la couche de contact 12 entourant ces électrodes ; cette surface de contact supérieure est référencée 16. Parallèlement, on appellera surface de contact inférieure la partie de la semelle de maintien 2 déposée sur la face inférieure de la pièce plate 4 et constituée notamment de l'électrode 10 et de la couche de contact 12 entourant cette électrode. Cette surface de contact inférieure porte la référence 18.

Afin de permettre la mise en oeuvre du collage électrostatique du substrat 1 sur la semelle de maintien 2 et de la semelle de maintien 2 sur le support 3, la couche de contact 12 en matériau diélectrique doit répondre à des critères de fonctionnement spécifiques : le matériau diélectrique doit être tel qu'il permette d'appliquer des forces coulombiennes suffisamment élevées pour créer une force électrostatique supérieure ou égale à 5 Torr entre, d'une part, le substrat et la semelle de maintien et, d'autre part, entre la semelle de maintien 2 et le support.

Avantageusement, la force électrostatique créée par la semelle de maintien 2 est comprise entre 10 et 20 Torr.

Pour obtenir une couche de contact 12 ayant de telles propriétés, on peut utiliser, par exemple, un film diélectrique en polyimide auto-adhésif d'épaisseur 60 µm, de constante diélectrique 4 et de rugosité moyenne statistique inférieure à 1 µ. Une telle couche de contact 12 permet d'obtenir une force électrostatique d'environ 10 Torr.

Selon un mode de réalisation particulier de l'invention, la semelle de maintien 2 peut comporter dans l'une ou l'autre des surfaces de contact 16, 18, ou dans les deux, un circuit d'écoulement d'un gaz caloporteur. Ce circuit d'écoulement n'est pas représenté sur les figures par mesure de simplification. Un tel circuit d'écoulement de gaz caloporteur peut consister en une pluralité de canaux réalisés à la surface de la couche de contact 12. Un tel circuit d'écoulement de gaz caloporteur peut être réalisé aussi bien sur la surface de contact supérieure 16 pour permettre de diminuer la résistance thermique de l'interface entre le substrat et la semelle de maintien 2 que sur la couche de contact 12 de la surface de contact inférieure 18 pour diminuer la résistance thermique de l'interface entre la semelle de maintien 2 et le support.

A titre d'exemple, le gaz caloporteur peut être de l'hélium.

Sur la figure 3, on a représenté une partie du porte-substrat aux environs de l'introduction du connecteur 5b dans la semelle. Cette figure 3 montre donc une portion de la semelle de maintien 2 autour du connecteur 5b et une portion du support 3 aux alentours de l'orifice par lequel le connecteur 5b pénètre dans le porte-substrat.

En effet, le connecteur 5b traverse le support 3 et une partie de la semelle de maintien 2 pour amener la tension sur l'électrode 8. En outre, un orifice 14 est réalisé dans la pièce plate 4 et recouvert, sur sa paroi, d'un dépôt de matériau électriquement conducteur. Avantageusement, ce dépôt conducteur est identique à celui réalisant l'électrode 8. On peut donc considérer que l'électrode 8 se poursuit jusque dans l'orifice 14 de la pièce plate 4.

Le connecteur 5b comportant un noyau 9 en matériau électriquement conducteur, l'électrode 8 recouvrant la paroi de l'orifice 14 peut entrer en contact avec ce noyau 9. Toutefois, ce noyau 9 est entouré d'une couche 7 de matériau diélectrique suffisamment épaisse pour qu'aucun contact ne puisse s'établir entre le connecteur 5b et tout autre élément du porte-substrat dont, en particulier l'électrode 10 et le support 3, tous deux électriquement conducteurs et traversés par ledit connecteur 5b.

Pour plus de détails concernant ce connecteur de tension, on peut se reporter à la demande de brevet française FR-A-2 683 395.

On précise cependant que le connecteur utilisé pour amener de la tension sur l'électrode filiforme 6 est tout à fait identique au connecteur 5b. Au contraire, le connecteur utilisé pour amener la tension sur l'électrode 10 peut être sensiblement différent du connecteur 5b dans le sens où ce conducteur traverse le support 3 et débouche directement au droit de l'électrode 10. Un tel connecteur de tension constitue l'un des modes de réalisation du connecteur décrit dans la demande de brevet FR-A-2 683 395.

Aussi, aux environs de ce connecteur pour l'électrode 10, la semelle de maintien 2 ne comporte pas d'orifice 14.

Selon un autre mode de réalisation de la semelle de maintien 2, la pièce plate 4 peut être un disque de céramique d'alumine revêtu, sur sa face supérieure, de deux électrodes entrelacées et ayant des surfaces sensiblement équivalentes et, sur sa face inférieure, d'une seule électrode circulaire comme dans le mode de réalisation décrit ci-dessus. Dans ce mode de réalisation, l'une des électrodes déposée sur la face supérieure de la pièce plate 4 est reliée électriquement à l'électrode recouvrant la surface inférieure de cette pièce plate 4. Ces deux électrodes connectées sont portées à une haute tension au moyen d'un connecteur tel que celui décrit précédemment ; la seconde électrode déposée sur la face supérieure de la pièce plate 4 étant quant à elle reliée au potentiel 0 au moyen également d'un connecteur. Cette liaison électrique entre deux électrodes a pour effet de réduire la capacité intrinsèque du porte-substrat, ce qui peut constituer un avantage certain dans des applications spécifiques telles que celles où l'on veut confiner un plasma sur le substrat, par exemple avec une polarisatin basse fréquence.

Dans un autre mode de réalisation particulier, il est possible de maintenir le support 3 a un potentiel flottant, notamment lorsqu'il s'agit de décharges en radiofréquence capacitives. Ce potentiel frottant est réalisé par un mode de fixation de type bipolaire sur la surface de contact inférieure 18de la semelle de maintien 2. La face inférieure de la pièce plate 4 est alors recouverte de deux électrodes distinctes, de formes sensiblement semblables aux électrodes 6 et 8 de la face supérieure de la pièce plate 4 et portées à des potentiels différents.

Pour une application particulière selon laquelle un porte-substrat est placé dans une enceinte génératrice d'un plasma sous-vide, le support 3 peut être une électrode radiofréquence refroidie par eau de manière à refroidir le substrat (en l'occurrence une plaquette de silicium) soumise au bombardement du plasma.

Pour des applications, où le porte-substrat est utilisé dans des machines de dépôt de couches minces sur des plaquettes de silicium à basse pression, le support 3 peut être un élément chauffant qui permet ainsi d'activer thermiquement la réaction chimique en phase vapeur.

Pour des applications, où le support sert tout simplement à transporter une plaquette, notamment sous vide, le porte-substrat électrostatique de l'invention a l'avantage d'exercer une force plus importante que la force apportée par des moyens classiques, ce qui permet des mouvements ayant une accélération importante.

## Revendications

1. Porte-substrat électrostatique comprenant :
- une semelle de maintien (2) ayant une surface de contact supérieure (16) apte à supporter un substrat (1) et à le maintenir dans une position choisie par collage électrostatique, et
- un support (3) solidaire de ladite semelle de maintien,
caractérisé en ce que la semelle de maintien comporte en outre une surface de contact inférieure (18) adhérant au support (3) par collage électrostatique.

2. Porte-substrat électrostatique selon la revendication 1, caractérisé en ce que la semelle de maintien comporte une pièce plate (4) électriquement isolante et thermiquement conductrice, ayant une face supérieure recouverte par au moins deux électrodes (6, 8) concentriques portées à des potentiels différents et une face inférieure recouverte d'au moins une électrode (10), chacune de ces électrodes étant elle-même recouverte d'une couche de matériau diélectrique (12).

3. Porte-substrat électrostatique selon la revendication 2, caractérisé en ce que la pièce plate est réalisée en un matériau thermiquement conducteur recouvert d'au moins une couche de matériau électriquement isolant.

4. Porte-substrat électrostatique selon la revendication 2 ou 3, caractérisé en ce que chaque électrode de la pièce plate est portée à une tension choisie, amenée au moyen d'un connecteur de tension (5a, 5b, 5c).

5. Porte-substrat électrostatique selon la revendication 4, caractérisé en ce que la pièce plate comporte, pour chaque électrode recouvrant la face supérieure de ladite pièce plate, au moins un orifice (14) transversal débouchant en regard de l'électrode et assurant le passage d'un connecteur de tension.

6. Porte-substrat électrostatique selon l'une quelconque des revendications 2 à 5, caractérisé en ce que la semelle de maintien comporte un circuit d'écoulement d'un gaz caloporteur réalisé en surface de la couche de matériau diélectrique.
